# EUROPÄISCHE PATENTSCHRIFT

(11) **EP 0 301 256 B1**
(45) Veröffentlichungstag und Bekanntmachung des Hinweises auf die Patenterteilung: **25.01.1995**
(21) Anmeldenummer: 88110311.3
(22) Anmeldetag: 28.06.1988
(51) Int. Cl.: H01J 37/24, G01R 31/28

(54) **Vorrichtung zur Modulation der Intensität eines Korpuskularstrahls**
Equipment for modulating the intensity of a corpuscular ray
Dispositif pour moduler l'intensité d'un rayon corpusculaire

(30) Priorität: 29.07.1987 DE 3725189
(43) Veröffentlichungstag der Anmeldung: 01.02.1989
(73) Patentinhaber: ICT Integrated Circuit Testing Gesellschaft für Halbleiterprüftechnik mbH, D-85551 Kirchheim (DE); ADVANTEST CORPORATION, Shinjuku-ku, Tokyo 163-08 (JP)
(72) Erfinder: Winkler, Dieter, Dipl.-Ing., D-8000 München 83 (DE)
(74) Vertreter: Tetzner, Volkmar, Dr.-Ing. Dr. jur.

(56) Entgegenhaltungen:
- HOSOKAWA et al. "Gigahertz Stroboscopy with the SEM", Band 49, Nr. 9, September 1978, Review of Scientific Instruments, Seiten 1293-1299
- SADORF et al. "Plug-in Fast Electron Beam Chopping System", Band 56, Nr. 4, April 1985, Review of Scientific Instruments, Seiten 567-571
- Ludwig Reimer: Scanning Electron Microscopy, Springer Verlag, Seiten 40-44
- Eberhard Menzel: Elektronenstrahlsystem für die Funktionskontrolle und Fehleranalyse höchstintegrierter Schaltkreise, Dissertation, Duisburg (1981), Seiten 17-19

## Beschreibung

Die Erfindung betrifft eine Vorrichtung zur Modulation der Intensität eines Korpuskularstrahls nach dem Oberbegriff des Patentanspruchs 1.

Strahlaustastsysteme zum Pulsen eines Elektronenstrahls sind aus Rev. Sci. Instrum. 56 (4), April 1985, S. 567 - 571; Rev. Sci. Instrum. 49 (9), September 1978, S. 1293 - 1299 und J. Phys. E, Sci. Instrum. 11 (1978), S. 529 - 532 bekannt. Ihre Verwendung in modifizierten Rasterelektronenmikroskopen und Elektronenstrahlmeßgeräten ermöglicht unter anderem die stroboskopische Abtastung hochfrequenter elektrischer Signale in Bauelementen der Mikroelektronik, insbesondere VLSI-Schaltungen. Um die Zeitabhängigkeit der an Leiterbahnen solcher Schaltungen auftretenden Signale mit Hilfe der beispielsweis in Microelectronic Engineering 4 (1986), S. 77 bis 106 oder Microelectronic Engineering 5 (1986), S. 523 bis 530 beschriebenen Sampling-Verfahren vollständig aufzuzeichnen, muß man die durch den Eintastzeitpunkt definierte Phasenlage der vom Strahlaustastsystem erzeugten Elektronenpakete (Pulsbreite τ = 10 bis 300 ps) oftmals über einen durch die Periodendauer des Signals vorgegebenen Zeitbereich von 10 bis 100 ns schieben.

In konventionellen Elektronenstrahlmeßgeräten wird die Phasenschiebung üblicherweise mit Hilfe mechanischer Ausziehleitungen durchgeführt, um eine zeitstabile Verzögerung des den Pulsgenerator des Strahlaustastsystems ansteuernden Triggersignals zu gewährleisten. Mechanische Phasenschieber besitzen allerdings den Nachteil, daß sehr lange Verzögerungsleitungen zur Aufzeichnung eines Signals über einen Zeitbereich von 10 bis 100 ns erforderlich sind. Außerdem muß eine erhebliche Dämpfung des Triggersignals in Kauf genommen werden, was eine spürbare Verringerung der die Zeitauflösung beeinflussenden Phasenstabilität der Anordnung zur Folge hat (Jitter). Ferner ist es nicht möglich, die Phasenlage der Elektronenpulse sprunghaft zu wechseln, da sich die Länge der Ausziehleitungen nur kontinuierlich ändern läßt.

Die Verwendung elektronischer Laufzeitglieder zur Verzögerung des Triggersignals kommt nicht in Betracht, da diese Geräte nicht die für Messungen an schnellen digitalen Schaltungen erforderliche Zeitstabilität aufweisen.

Der Erfindung liegt die Aufgabe zugrunde, eine Vorrichtung der eingangs genannten Art anzugeben, mit der eine hohe Zeitstabilität der Phasenschiebung bei stroboskopischen Messungen erreicht wird. Diese Aufgabe wird erfindungsgemäß durch eine Vorrichtung nach Patentanspruch 1 gelöst.

Der mit der Erfindung erzielbare Vorteil besteht insbesondere darin, daß Signale in schnellen digitalen Schaltungen mit hoher Zeitauflösung gemessen werden können.

Die Ansprüche 2 bis 8 betreffen bevorzugte Ausgestaltungen und Weiterbildungen der Erfindung, die nachfolgend anhand der Zeichnungen näher erläutert wird.

Hierbei zeigt
FIG 1 den schematischen Aufbau einer erfindungsgemäßen Vorrichtung zum Pulsen eines Elektronenstrahls.
FIG 2 Signale zur Ansteuerung der Austastkondensatoren der Vorrichtung nach FIG 1.

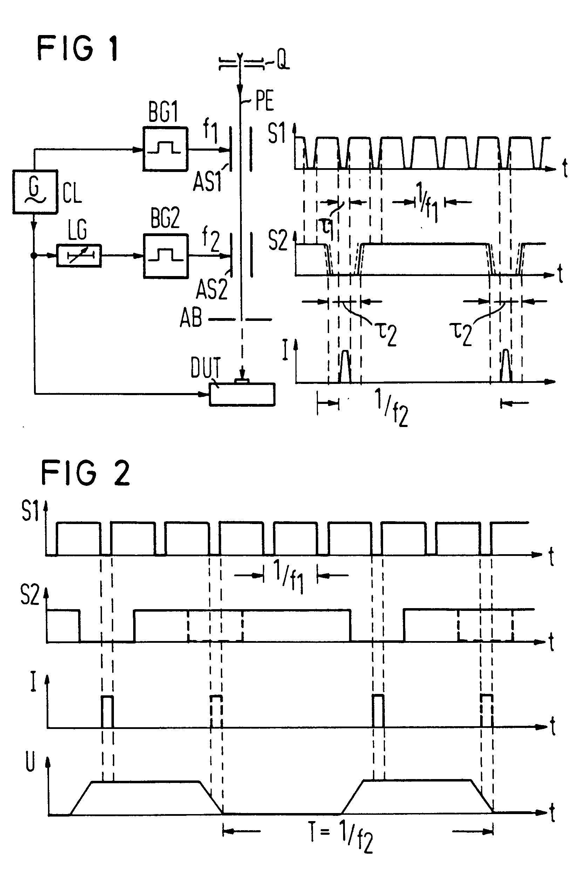

Die in FIG 1 schematisch dargestellte Vorrichtung kann insbesondere in den aus den eingangs zitierten Veröffentlichungen bekannten Elektronenstrahlmeßgeräten zum Pulsen des Primärstrahls eingesetzt werden. Sie besteht im wesentlichen aus zwei von einer Synchronisiereinheit CL (Referenzoszillator, Clock) angesteuerten Pulsgeneratoren BG1, BG2, einem dem Pulsgenerator BG2 vorgeschalteten Verzögerungselement, insbesondere einem elektronischen Laufzeitglied LG zur steuerbaren Verzögerung des von der Synchronisiereinheit CL erzeugten Triggersignals und zwei in der elektronenoptischen Säule des Elektronenstrahlmeßgerätes üblicherweise zwischen der Quelle Q und der ersten Kondensorlinse angeordneten Austastkondensatoren AS1 und AS2, die mit den im rechten Teil der FIG 1 dargestellten Ausgangssignalen S1 und S2 der Pulsgeneratoren BG1 bzw. BG2 belegt werden. Anstelle von Plattenkondensatoren kann man selbstverständlich auch andere Austasteinrichtungen, beispielsweise die aus dem J. Phys. E: Sci. Instrum., Vol. 11, 1978, Seite 529 bis 532 bekannten Wanderwellenstrukturen verwenden. Da die Synchronisiereinheit CL sowohl die Pulsgeneratoren BG1 und BG2 als auch das zu überprüfende Bauelement DUT, beispielsweise eine schnelle digitale Schaltung, ansteuert, ist sichergestellt, daß die Primärelektronenpulse immer synchron mit dem zu messenden internen Signal U eingetastet werden. Wie den Zeitdiagrammen zu entnehmen ist, erreichen die von der Quelle Q emittierten Elektronen PE nur dann die in der evakuierten Probenkammer des Elektronenstrahlmeßgerätes eingebrachte Bauelement DUT, wenn diese die Austastkondensatoren BS1 und BS2 während der Zeitintervalle τ₂ bzw. τ₂′ (τ₂ = τ₂′ ≈ 0.5 ns) durchlaufen. Zu allen anderen Zeiten t erfahren die Elektronen PE im elektrischen Feld eines der Plattenpaare eine so große Ablenkung, daß sie auf die im Strahlengang hinter dem Austastkondensatoren angeordnete Blende AB auftreffen. Auf der Probe DUT beobachtet man deshalb einen mit der Frequenz f₂ des Signals S2 gepulsten Primärelektronenstrom I(t), der die im unteren Diagramm schematisch dargestellte Zeitabhängigkeit aufweist. Bei stroboskopischen Messungen wird der untere Austastkondensator AS2 mit der Frequenz f₂ von beispielsweise 10 MHz des an einer Leiterbahn anliegenden Signals U angesteuert, so daß pro Periode T = 1/f₂ jeweils nur ein Elektronenpuls die Bausteinoberfläche erreicht. Die die Zeitauflösung definierende Elektronenpulsbreite τₚ ≈ τ₁ ≈ 10 ps ist hierbei ausschließlich durch den mit dem Signal S1 der Frequenz f₁ von beispielsweise 10 GHz beaufschlagten oberen Austastkondensator AS1 bestimmt. Um die Phasenlage der Primärelektronenpulse bezüglich des abzutastenden Signals U zu ändern, wird das den Pulsgenerator BG2 ansteuernde Triggersignal der Synchronisiereinheit CL mit Hilfe des elektronischen Laufzeitgliedes LG um die der Phasenänderung entsprechende Zeit verzögert. Wie die FIG 2 zeigt, führt die Verzögerung des Triggersignals zu einer Phasenverschiebung zwischen den an den Austastkondensatoren AS1 und AS2 anliegenden Signalen S1 bzw. S2, so daß die Elektronenpulse nicht mehr das Plateau des an der Leiterbahn anliegenden Signals U (unteres Diagramm der FIG 2) sondern dessen abfallende Flanke abtasten. So läßt sich bei einer Frequenz f₁ = 10 GHz und f₂ = 10 MHz ein Zeitbereich von 100 ms in Schritten von 100 ps aufzeichnen.

Die Phasenstabilität des Systems ist ausschließlich durch die Zeitstabilität des am Austastkondensator AS1 anliegenden Signals S1 bestimmt. Man kann deshalb konventionelle elektronische Laufzeitglieder LG zur Verzögerung des Triggersignals verwenden, da sich deren Phaseninstabilität (Jitter) bei einer Pulsbreite des Signals S2 von beispielsweise τ₂ ≈ 0.5 ns nicht mehr störend auswirkt (siehe mittleres Diagramm der FIG 1).

Die Erfindung ist selbstverständlich nicht auf das beschriebene Ausführungsbeispiel beschränkt. So ist es ohne weiteres möglich, die Reihenfolge der Austastkondensatoren AS1 und AS2 im Strahlengang zu vertauschen oder den Austastkondensator AS2 um 90° gedreht in der Ebene des Austastkondensators AS1 anzuordnen.

Es ist nicht notwendig, eine zusätzliche Blende in den Strahlengang des Elektronenstrahlmeßgerätes einzubringen. Als Blende AB können auch die üblicherweise vorhandenen Strahlblenden verwendet werden.

Zur sprunghaften Änderung der Phasenlage der Teilchenpulse ist es von Vorteil, mehrere parallelgeschaltete Laufzeitglieder bzw. Verzögerungselemente und einen elektronischen Schalter vorzusehen.

Kleinere Zeitbereiche eines Signals kann man wie bisher mit Hilfe mechanischer Ausziehleitungen aufzeichnen. Außerdem ist es möglich, den die Phasenlage definierenden Eintastzeitpunkt der Teilchenpulse durch eine Änderung der Nullspannung der Austastkondensatoren zu verschieben. Dies ist insbesondere für das Abtasten kleinerer Zeitbereiche (Signalflanken) von Vorteil.

Die aus dem Pulsgenerator BG1 und den Austastkondensator AS1 bestehende Einrichtung zur Modulation der Intensität des Teilchenstrahls kann auch durch eine mit der Frequenz f₁ gepulste Quelle Q ersetzt werden, wie sie beispielsweise aus Appl. Phys. Lett. Bd. 51, 13.06.87, Seite 145 bis 147 bekannt ist.

Die Erfindung kann selbstverständlich auch in einem optischen Rastermikroskop (Raster-Lasermikroskop) zum Pulsen des Primärstrahls verwendet werden. Die als Intensitätsmodulatoren wirkenden Austastkondensatoren AS1 und AS2 sind dann durch elektroakustische bzw. elektrooptische Elemente (beispielsweise Pockels-Zellen) zu ersetzen.

## Patentansprüche

1. Vorrichtung zur Modulation der Intensität eines Korpuskularstrahls (PE), die einen von einem ersten Signalgenerator (BG1) angesteuerten ersten Intensitätsmodulator (AS1) und einen von einem zweiten Signalgenerator (BG2) angesteuerten zweiten Intensitätsmodulator (AS2) enthält,
**dadurch gekennzeichnet**,
- daß der erste Signalgenerator (BG1) ein eine erste Frequenz (f1) aufweisendes erstes Ausgangssignal (S1) erzeugt,
- daß der zweite Signalgenerator (BG2) ein eine zweite Frequenz (f2) aufweisendes zweites Ausgangssignal (S2) erzeugt, wobei die zweite Frequenz (f2) kleiner ist als die erste Frequenz (f1),
- daß dem zweiten Signalgenerator (BG2) ein Verzögerungselement (LG) vorgeschaltet ist, dessen Verzögerung sich steuern läßt und
- daß der erste Signalgenerator (BG1) und das Verzögerungselement (LG) mit einem Ausgangssignal eines Taktgebers (CL) beaufschlagt sind.

2. Vorrichtung nach Anspruch 1,
**gekennzeichnet durch**
ein Strahlaustastsystem (AS1, AS2) als Intensitätsmodulator.

3. Vorrichtung nach Anspruch 2,
**gekennzeichnet durch**
ein einen Ablenkkondensator und eine Blende enthaltendes Strahlaustastsystem.

4. Vorrichtung nach Anspruch 2,
**gekennzeichnet durch**
ein eine Wanderwellenstruktur und eine Blende enthaltendes Strahlaustastsystem.

5. Vorrichtung nach Anspruch 1,
**gekennzeichnet durch**
ein elektroakustisches oder elektrooptisches Element als Intensitätsmodulator.

6. Vorrichtung nach Anspruch 1,
**dadurch gekennzeichnet**,
daß die aus einem ersten Signalgenerator (BG1) und dem ersten Intensitätsmodulator (AS1) bestehende Einheit durch eine mit der ersten Frequenz (f₁) gepulste Korpuskularstrahlquelle ersetzt ist.

7. Vorrichtung nach einem der Ansprüche 1 bis 6,
**gekennzeichnet durch**
einen Oszillator als Taktgeber.

8. Vorrichtung nach einem der Ansprüche 1 bis 7,
**dadurch gekennzeichnet**,
daß die zweite Frequenz (f₂) der Frequenz eines in einer Probe (DUT) auftretenden Signals (U) entspricht.

## Claims

1. Device for modulating the intensity of a corpuscular beam (PE), which device includes a first intensity modulator (AS1) driven by a first signal generator (BG1) and a second intensity modulator (AS2) driven by a second signal generator (BG2), characterized in that
- the first signal generator (BG1) generates a first output signal (S1) exhibiting a first frequency (f₁),
- the second signal generator (BG2) generates a second output signal (S2) exhibiting a second frequency (f₂), the second frequency (f₂) being lower than the first frequency (f₁),
- ahead of the second signal generator (BG2) there is connected a delay element (LG) the delay of which can be controlled, and
- the first signal generator (BG1) and the delay element (LG) receive an output signal of a clock generator (CL).

2. Device according to Claim 1, characterized by a beam blocking system (AS1, AS2) as intensity modulator.

3. Device according to Claim 2, characterized by a beam blocking system including a deflecting capacitor and a diaphragm.

4. Device according to Claim 2, characterized by a beam blocking system including a travelling wave structure and a diaphragm.

5. Device according to Claim 1, characterized by an electroacoustic or electrooptic element as intensity modulator.

6. Device according to Claim 1, characterized in that a unit comprising a first signal generator (BG1) and the first intensity modulator (AS1) is replaced by a corpuscular beam source which is pulsed with the first frequency (f₁).

7. Device according to one of Claims 1 to 6, characterized by an oscillator as clock generator.

8. Device according to one of Claims 1 to 7, characterized in that the second frequency (f₂) corresponds to the frequency of a signal (U) occurring in a specimen (DUT).

## Revendications

1. Dispositif pour moduler l'intensité d'un faisceau corpusculaire (PE), qui contient un premier modulateur d'intensité (AS1), commandé par un premier générateur de signaux (BG1), et un second modulateur d'intensité (AS2), commandé par un second générateur de signaux (BG2),
caractérisé par le fait
- que le premier générateur de signaux (BG1) produit un premier signal de sortie (S1) ayant une première fréquence (f1),
- que le second générateur de signaux (BG2) produit un second signal de sortie (S2) ayant une seconde fréquence (f2), la seconde fréquence (f2) étant inférieure à la première fréquence (f1),
- qu'en amont du second générateur de signaux (BG2) est branché un élément de retardement (LG), dont le retard peut être commandé, et
- que le premier générateur de signaux (BG1) et l'élément de retardement (LG) reçoivent un signal de sortie d'un générateur de cadence (CL).

2. Dispositif suivant la revendication 1, caractérisé par un système (AS1,AS2) de suppression du faisceau en tant que modulateur d'intensité.

3. Dispositif suivant la revendication 2, caractérisé par un système de suppression du faisceau contenant un condensateur de déviation et un diaphragme.

4. Dispositif suivant la revendication 2, caractérisé par un système de suppression du faisceau contenant une structure à ondes progressives et un diaphragme.

5. Dispositif suivant la revendication 1, caractérisé par un élément électroacoustique ou électro-optique en tant que modulateur d'intensité.

6. Dispositif suivant la revendication 1, caractérisé par le fait que l'unité constituée d'un premier générateur de signaux (BG1) et d'un premier modulateur d'intensité (AS1) est remplacée par une source de faisceau corpusculaire pulsée à la première fréquence (f₁).

7. Dispositif suivant l'une des revendications 1 à 6, caractérisé par un oscillateur en tant que générateur de cadence.

8. Dispositif suivant l'une des revendications 1 à 7, caractérisé par le fait que la seconde fréquence (f₂) correspond à la fréquence d'un signal (U), qui apparaît dans une sonde (DUT).
